# EUROPEAN PATENT APPLICATION

(11) **EP 4 716 040 A1**
(43) Date of publication of application: **25.03.2026**
(21) Application number: 25156037.1
(22) Date of filing: 05.02.2025
(51) Int. Cl.: H02B 1/28, H02B 1/40

(54) **AN ENCLOSURE**

(30) Priority: 18.09.2024 GB 202413754
(71) Applicant: Electrix International Limited, Bishop Auckland, County Durham DL14 6XP (GB)
(72) Inventor: THOMPSON, CHRISTOPHER, Bishop Auckland, DL14 6XP (GB)
(74) Representative: Archer, Graham John

(57) **Abstract**

An enclosure is disclosed and in particular a stainless steel sealed enclosure for containing electrical components is disclosed. The enclosure includes a body having an aperture extending into an interior volume of the enclosure and a lid. The enclosure also includes a first seal, a second seal and a retainer plate. The first seal encircles the aperture and engages with the first surface of the retainer plate, securely fastening the first seal to the body. The second seal engages the second surface of said retainer plate, encircling the aperture. Lastly, the lid for covers the aperture of the body and engages said first seal and said second seal.

## Description

The present invention relates to an enclosure and relates particularly, but not exclusively, to a stainless steel sealed enclosure for containing electrical components.

An enclosure designed to house electrical components must provide thorough protection against environmental factors such as bacteria, water and dust. Ensuring that the enclosure is waterproof and sealed is important to prevent water from reaching the components inside and damaging sensitive electrical equipment.

In industrial premises where maintaining cleanliness is essential, such as in the pharmaceutical, food and beverage industries, it is vital that all surfaces are easy to clean and waterproof. These components should ideally offer a waterproof seal to safeguard the electrical parts inside whilst also ensuring both hygiene and safety procedures are met. It is a particular problem where the lid of the enclosure meets the body as this is a junction between two metallic surfaces. As a result, this must be sealed so as to completely prevent any water entry but must also be formed to minimise the creation of dirt traps and allow the whole device to be easy to clean.

Preferred embodiments of the present invention seek to overcome or alleviate the above described disadvantages of the prior art.

According to an aspect of the present invention there is provided an enclosure for containing electrical components, the enclosure comprising:
a body having a rear wall and a front wall having at least one side wall extending therebetween, wherein the front wall has an aperture formed therethrough that allows access to an interior volume of the body;
a first seal extending around the aperture wherein an outermost edge of the first seal encircles the aperture;
a retainer plate having a first surface and a second surface wherein an outermost edge of the retainer plate encircles the aperture and the first seal engages the first surface and the retainer plate fixes the first seal to the body;
a second seal engaging the second surface of the retainer plate wherein an outer edge of the second seal encircles the aperture; and
a lid for covering the aperture of the body wherein the lid engages the first seal and the second seal.

Including two seals between the lid and the body of the enclosure provides an additional layer of protection against environmental factors, such as water, dust and contaminants. These dual seals reduce the risk of water ingress that could damage the electrical components inside the enclosures. Secondly, two seals ensures that even if one seal fails the second seal can remain functional. This enables the enclosure to maintain its waterproof ability whilst allowing time for a broken seal to be replaced.

By including a first seal that prevents water, cleaning solutions and bacteria from entering the interface between the lid and the body, potential damage and inward leakage of contaminants is prevented.

Including a second seal that prevents water from entering the internal volume of the enclosure further ensures that the electrical components located within the internal volume of the enclosure are safe.

Additionally, the inclusion of a second seal ensures a high ingress protection(IP) rating. By providing an additional barrier the second seal ensures that the enclosure remains tightly sealed, preventing any bacteria from entering or exiting between the lid and the body. This is especially important when the enclosure is being used in an environment requiring a high standard of hygiene such as in the food industry.

Integrating the seals directly into the enclosure offers the advantage of making the quality of the seal, specifically its ability to prevent water ingress, less reliant on the expertise of the installer. Additionally, the reliability of these seals can be verified during the manufacturing process therefore reducing the risk of installation errors that could lead to an unsealed enclosure. When the lid engages with the first and second seal, it ensures a double seal relative to the interior of the enclosure.

Finally, the retainer plate makes maintenance easier as the seal can be inspected without risk of it moving out of place.

In a preferred embodiment the retainer plate applies a compression force to the first seal.

By including a retainer plate that applies a compression force to the first seal ensures that the seal remains securely positioned and prevents it from moving or becoming dislodged.

In a preferred embodiment the enclosure further comprises a third seal adjacent the first seal and engaging the first surface of the retainer plate.

By including a third seal provides a third layer of protection against water ingress and the potential of bacteria entering the enclosure.

In preferred a embodiment the third seal is removable.

By enabling removal of the third seal, the seal can be simply detached from the enclosure and cleaned when required. Furthermore, if the seal is damaged it can be replaced with ease.

In a preferred embodiment the third seal is fixed.

In another preferred embodiment the retainer plate comprises a rim wherein the rim engages the body of the enclosure, forming a recess for the first seal to engage.

In a further preferred embodiment, the rim comprises metal.

In an additional preferred embodiment, the second seal is fixed to the lid.

Fixing the second seal to the lid ensures proper installation, eliminating dependence on the skill of the installer.

In a preferred embodiment the first seal is fixed to the body of the enclosure.

In another preferred embodiment the first seal is removeable.

By enabling removal of the first seal, it can be easily detached from the enclosure for cleaning when needed. Additionally, if the seal is damaged it can be replaced quickly and effortlessly. As a result, enabling the first seal to be removable provides the benefit of making the maintenance and inspection processes easier. When the first seal has been removed it is easier to clean or replace without disassembling the entire enclosure.

In a further preferred embodiment, the retainer plate comprises at least one second aperture for a fixing member to extend therethrough and removably fix the first seal to the front wall of said body.

In an additional preferred embodiment, said lid comprises a fixing device for fixing said lid to said body of the enclosure.

In a preferred embodiment, said second seal comprises neoprene.

In another preferred embodiment, the first seal comprises silicone.

In a further preferred embodiment, the lid comprises a front surface and at least one side extending from the front surface wherein at least one edge of the side engages the first seal.

Preferred embodiments of the present invention will now be described, by way of example only, and not in any limitative sense with reference to the accompanying drawings in which:-
Figure 1 is a perspective view of an enclosure of a first embodiment of the present invention;
Figure 2 is a front view of a body of the enclosure of figure 1;
Figure 3 is a partial cutaway front view of the body of the enclosure of figure 1;
Figure 4 is a rear view of a lid of the enclosure of figure 1;
Figure 5 is a partial cutaway front view of a body of an enclosure of a second embodiment of the present invention;
Figure 6 is a rear view of a lid used with the body of figure 5;
Figure 7 is a cross-sectional view of the enclosure of figure 5;
Figure 8 is an exploded view of the enclosure of figure 5; and
Figure 9 is a top view of a first and second seal of the body of figure 5.

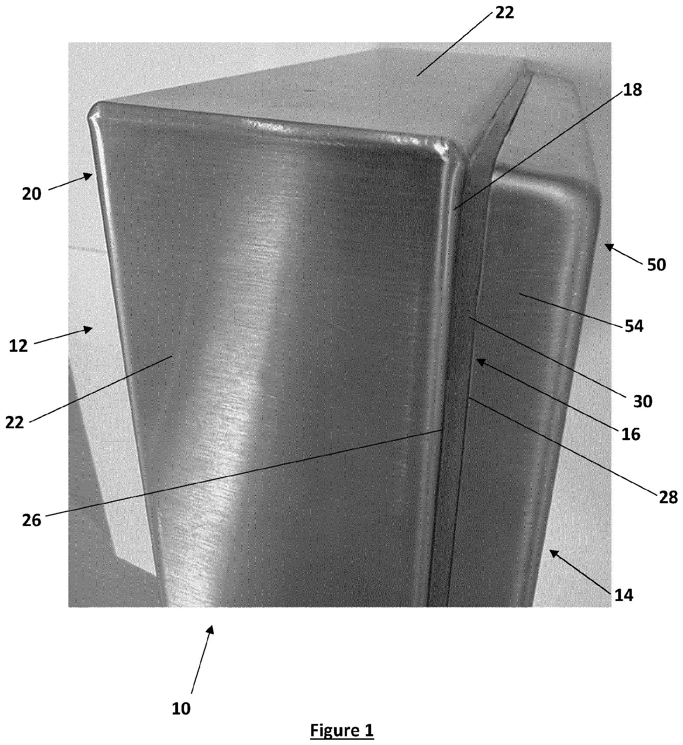

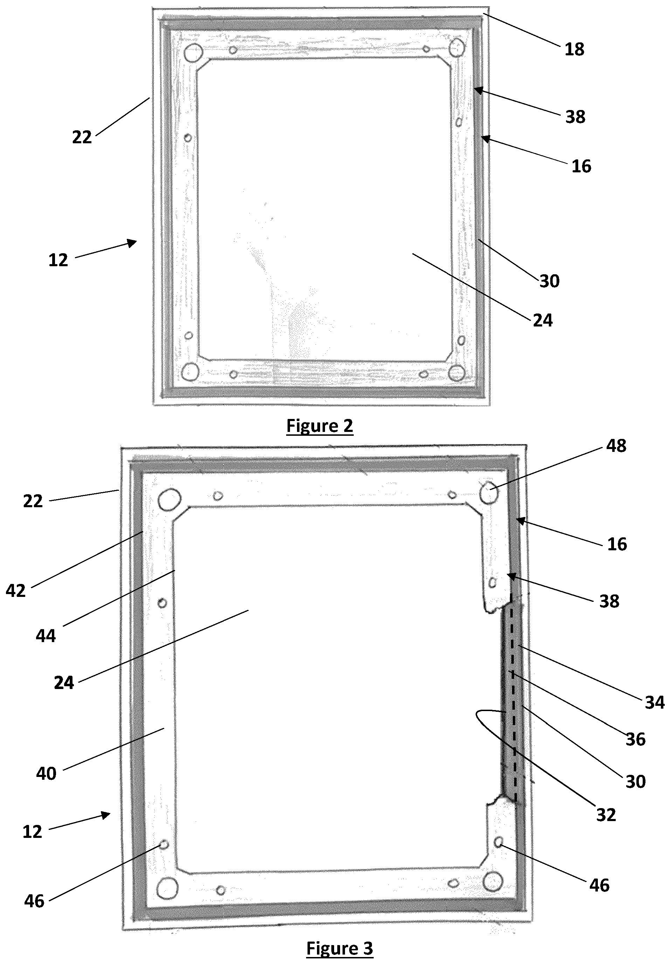

Referring initially to figure 1, an enclosure 10 is provided for containing electrical components such as wires, cables and the like and is designed to be fixed onto a surface such as a wall. The enclosure 10 includes a body 12, formed in the shape of a cuboid, a lid 14 and a first seal 16 located between the interface of the body and the lid. The lid 14 is removably attached to the body 12 and the first seal 16 is fixed to the body. The body 12 includes a front wall 18, a rear wall 20 and four side walls 22 extending therebetween.
Referring additionally to figures 2 and 3, extending through the front wall 18 of the body 12 is an aperture 24. The aperture 24 allows access into the interior volume of the enclosure 10 when the lid 14 is removed. This enables the installation or maintenance of the electrical components inside.

Encircling the aperture 24 and fixed to the body 12 of the enclosure is the first seal 16. Manufactured from a rubberised material such as neoprene or more preferably silicone, the first seal 16 includes, on one side, a first contact area 26 and a second contact area 28 on the other side. Extending between the first contact area 26 and the second contact area 28 is a first outermost edge 30 and a first innermost edge 32. Engaging the first contact area 26 is the front wall 18 of the body 12. The second contact area 28 includes a first portion 34 and a second portion 36. When the lid 14 is placed onto the enclosure 10 it engages the first portion 34 of the second contact area 28. The first seal 16 is sized such that it extends around the perimeter of the lid 14 creating the interface between the body 12 and the lid 16. Engaging the second portion 36 of the first seal 16 and used to fix the first seal to the front wall 20 of the enclosure 10 is a retainer plate 38.

The retainer plate 38 is substantially rectangular in shape and includes a first surface (not shown), a second surface 40, a plate aperture extending therethrough, a second outermost edge 42 and a second innermost edge 44. The second outermost edge 42 encircles the first aperture 24 of the body 12 and the second innermost edge 44 forms the edge of the aperture. Engaging the second portion 32 of the seal 16 is the first surface of the retainer plate 38. Figure 3 shows a cut away portion through the retainer plate 28 to highlight the second portion 36 of the first seal 18 underneath. To fix the seal 16 to the front wall 20 the retainer plate 38 has eight second apertures 46. The second apertures 46 are located along each side of the retainer plate 28, two for each side. Extending through each of these second apertures 46 is a fixing member in the form of a screw (not shown). The screws extend through the retainer plate 38 and into the front wall 18 of the body 12. When the screws are tightened, they pull the retainer plate 28 towards the first seal 16. This action compresses the first seal 16 between the front wall 18 of the body and retainer plate 38, fixing it in place. The retainer plate 38 further includes four third apertures 48 located at each corner. These third apertures 48 enable a second set of fixing members in the form of screws (not shown) to extend through into the front wall 18 of the body 12.

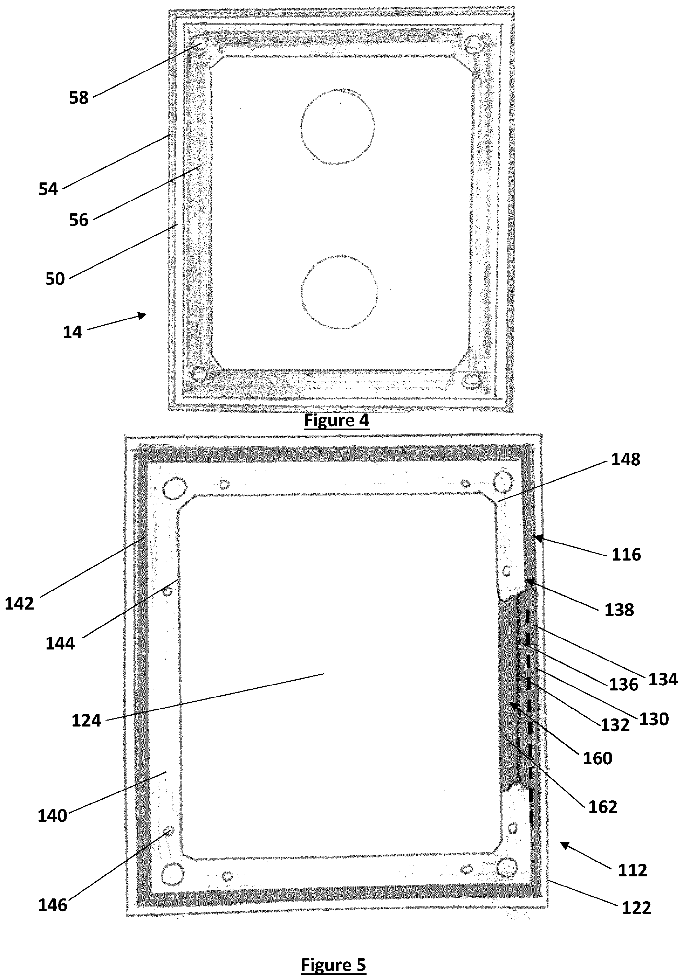

Referring additionally to figure 4, the lid 14 includes a front face 50, a rear face 52 and a rim 54. Located on the rear face 52 is a second seal 56. The second seal 56 is located within a recess (not shown) and is sized such that it forms the shape of the retainer plate 38 located in the body 12. The second seal 56 adheres to the rear face 52 through adhesive means, such as glue and is manufactured from a rubberised material such as silicone or more preferably neoprene. When the enclosure 10 is in use and the lid 14 is attached, the second seal 56 is pressed into engagement with the retainer plate 38. Furthermore, the rim 54 of the retainer plate 38 makes contact and engages the first seal 16. The lid 14 is secured to the body 10 by fixing members such as screws (not shown). The screws are threaded through four fourth apertures 58 located on the front face 50 of the lid 14. The fourth apertures 58 extend through the front and rear face 50 and 52 and align with the third apertures 48 located on the retainer plate 38 such that the tail of the screw can extend therethrough.

Figures 2 and 3 highlight an example of the retainer plate 38 being used to clamp and compress the first seal 16 against the front wall 18 of the body 12, ensuring the first seal remains in place. However, in an alternative embodiment (not shown in the figures) the retainer plate includes a rim that extends from the second innermost edge. The rim is secured to the front wall of the body by a fixing means such as a stud weld, screw, rivet or bolt. The rim forms a recess between the first surface of the retainer plate and the front wall of the body of the enclosure. The first seal 16 is inserted into the recess and is held in place by friction between the front wall and first surface of the retainer plate 38. Typically, the body 12, lid 14, retainer plate 38 and all of the fixing screws are formed from stainless steel in order to be easily cleaned while being corrosion resistant. However, other materials with similar properties can be used.

Installation and assembly of the enclosure 10 will now be described.

During the manufacturing process the first seal 16 is brought into contact with the body 12 of the enclosure 10. The first seal 16 is placed around the first aperture 24 such that the first contact area 26 of the first seal engages the front wall 18 of the body 12. Simultaneously, the first seal 16 is positioned such that the outermost edge 30 of the first seal encircles the first aperture. Next, the retainer plate 38 is placed on top of the second contact area 28 of the first seal 16 and the first surface (not shown) of the retainer plate 38 engages with the second portion 36 of the seal. Screws are then threaded through the second apertures 46 contacting the front wall of the enclosure 10. The screws are tightened such that the retainer plate 38 compresses the first seal 16, securing it in place.

Next, the enclosure 10 is secured to a surface such as a wall via screws or bolts (not shown) inserted through the rear wall 20 and into the wall. Any cables or wires that are to be installed are inserted into the aperture 24 and threaded into the wall or to another compartment, typically via sections of conduit.

Next, the lid 14 is placed over the aperture 24 such that the second seal 56 engages with the retainer plate 38 and the rim 54 engages with the first seal 56. Next, screws are inserted through the fourth apertures 58 on the front face. The screws extend through the lid 14 and into the third apertures 48 on the retainer plate securing the lid in place. Finally, the screws are tightened to ensure a strong connection between the lid 14, the first seal 16 and the body 12 of the enclosure 10. The enclosure 10 has been installed, closed and sealed to provide a substantially water enclosure which can be easily cleaned.

Referring now to figures 5 to 9, in which components equivalent to those in figures 1 to 4 have been identified with like reference numerals increased by 100, an enclosure 110 includes a cuboid-shaped body 112, a lid 114, a first seal 116, forming an interface between the body and the lid, a second seal 156, located on the lid, and a third seal 160. The body 112 includes a front wall 118 through which a first aperture 124 extends.

The first seal 116, removably attached to the body 112 of the enclosure, surrounds the aperture 124. Made from rubberised materials such as neoprene or more preferably silicone, the first seal 116 includes, on one side, a first contact area 126 and a second contact area 128 on the other side. Between these contact areas lies a first outermost edge 130 and a first innermost edge 132. Engaging the first contact area 126 is the front wall 118 of the body 112 and engaging a portion of the second contact area 128 is a retainer plate 138.

When the lid 114 is positioned on the enclosure 110, it contacts a first portion 134 of the second contact area 128. The first seal 116 is designed to extend around the entire perimeter of the lid 114, forming the junction between the body 112 and the lid 116. The retainer plate 138 is used to secure the first seal 116 to the front wall 120 of the enclosure 110 by engaging a second portion 136 of the first seal 116.

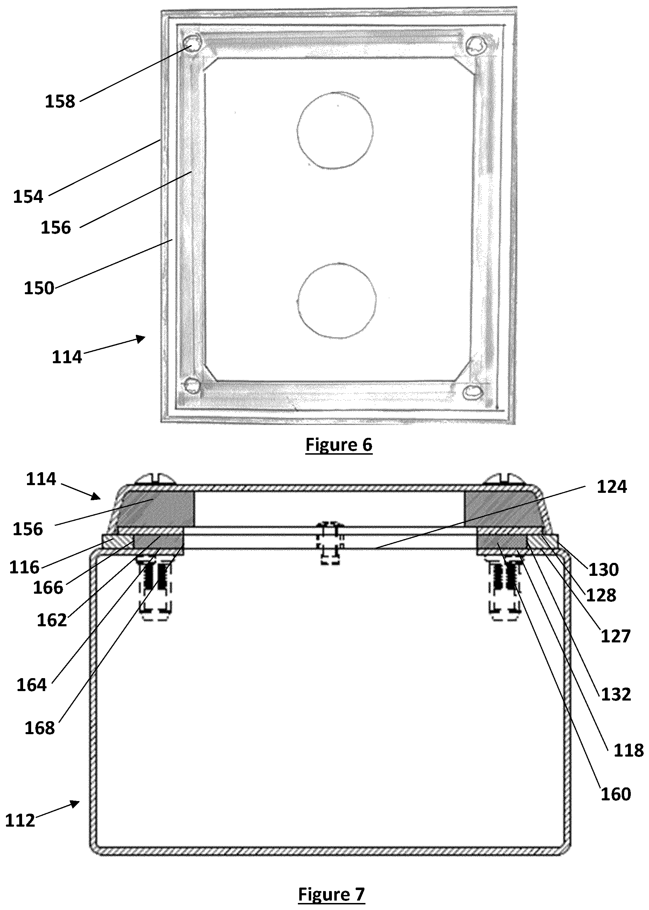

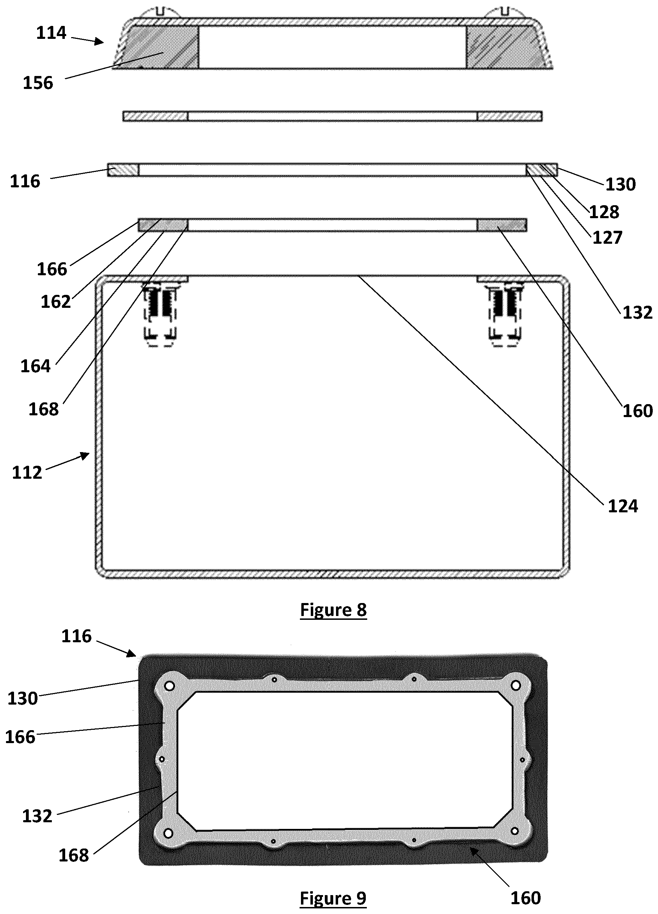

Adjacent the first seal 116 and extending along the innermost edge 132 is the third seal 160. The third seal 160 includes a third contact portion 162, and a fourth contact area 164 Engaging the third contact portion 162 is the retainer plate whilst the fourth contact portion engages the front wall of the body 112. Referring specifically to figure 9 that highlights the position of the first and third seals as they would be located together on the enclosure 110. The third seal 160 includes a second outermost edge 166 and a second innermost edge 168. Both the inner and outermost edges, 166 and 168 are located between the third and fourth contact portions, 162 and 164 (shown in figures 7 and 8). The second outermost edge 166 follows the contour of the first innermost edge 132 of the first seal 116. As such, the second and third aperture, 146 and 158 extend through the third seal 160 and do not extend through the first seal 116.

Between these contact areas lies a first outermost edge 130 and a first innermost edge 132. Engaging the first contact area 126 is the front wall 118 of the body 112 and engaging a portion of the second contact area 128 is a retainer plate 138.

Preferably the third seal 160 is manufactured from a rubberised material such as silicone. However, other such materials could be used. One such material is metal or other non-compressible material. By including a metal third seal 160 underneath the retainer plate 138, a recess (not shown) is formed between the third seal 160 and the retainer plate. This recess provides housing for the first seal 116 to be inserted thereinto by providing a friction fit between the retainer plate 138 and the third seal 160.

The rectangular shaped retainer plate 134 includes a first surface (not shown), a second surface 140, a plate aperture passing therethrough, a second outermost edge 142, and a second innermost edge 144. The second outermost edge 142 surrounds the first aperture 124 of the body 112, while the second innermost edge 144 defines the border of the plate aperture. The first surface of the retainer plate 134 engages with the second portion 132 of the first seal 116 along with the third contact portion 162 of the third seal 160. Figure 5 illustrates a cutaway portion of the retainer plate 128, revealing the first and third seals 116 and 160 beneath it. To secure the first and third seals 116 and 160 to the front wall 120, the retainer plate 134 includes eight second apertures 146. Each of the second apertures 146 accommodates a fixing member, such as a screw (not shown). These screws pass through the retainer plate 138 and into the front wall 118 of the body 112. When tightened, the screws draw the retainer plate 128 towards the first and the second seals 116, compressing them between the front wall 118 and the retainer plate 138, thereby securing them in place. Additionally, the retainer plate 138 includes four third apertures 148, one at each corner. These third apertures 148 allow for a second set of fixing members, also in the form of screws (not shown), to extend through and into the front wall 118 of the body 112. It should be noted that either or both the first and third seals can be glued into place before securing them with the retainer plate. Otherwise, they could be solely held in position by the compression force from the retainer plate.

Referring now to figure 6, the lid 114 features a front face, a rear face 152, and a rim 154. The rear face 152 houses a second seal 156, which fits within a recess (not shown) and is shaped to match the retainer plate 138. The second seal 156 adheres to the rear face 152 using self-adhesive means, glue, and is made from a rubberised material such as silicone or more preferably neoprene. When the enclosure 110 is in use and the lid 114 is attached, the second seal 156 is pressed into contact with the retainer plate 138. Additionally, the rim 154 of the retainer plate 38 engages the first seal 116. The lid 114 is secured to the body 112 with fixing members like screws (not shown). These screws are threaded through four fourth apertures 158 on the front face of the lid 114. The fourth apertures 518 extend through both the front and rear faces 150 and 152, aligning with the third apertures 148 on the retainer plate 138, allowing the screws to pass through.

Installation and assembly of the enclosure 10 will now be described.

During the manufacturing process, the first and second seals 116 are brought into contact with the body 112 of the enclosure 110. The seals are positioned around the first aperture 124 such that the first and fourth contact areas engage (not shown) the front wall 118 of the body 112. Following this, the retainer plate 138 is aligned on top of the second and third contact areas 128 and 162 of the first and second seals 116 and 160, with the first surface of the retainer plate engaging the second portion 136 of the seal. Screws are then inserted through the second apertures 146, contacting the front wall 118 of the enclosure 110. These screws are tightened, causing the retainer plate 138 to compress both seals 116 and 160, thereby securing them firmly in place.

Next, the enclosure 110 is mounted to a surface, such as a wall, using screws or bolts (not shown) that pass through the rear wall and into the surface. Any necessary cables or wires are then routed through the aperture 124 and directed into the wall or another compartment.

Following this, the lid 114 is positioned over the aperture 24, ensuring that the second seal 156 contacts the retainer plate 138 and the rim 154 aligns with the first seal 116. Next, screws are inserted through the fourth apertures 158 on the front face of the lid 114. These screws pass through the lid 114 and into the third apertures 148 on the retainer plate, securing the lid in place. Finally, the screws are tightened to establish a firm connection between the lid 114, the first seal 116, and the body 112 of the enclosure 110.

The preceding examples are a non-exhaustive list of suitable techniques and others are available which may be selected at the discretion of the person skilled in the art.

It will be appreciated by persons skilled in the art that the above embodiments have been described by way of example only and not in any limitative sense, and that various alterations and modifications are possible without departure from the scope of the protection which is defined by the appended claims. In particular, where various embodiments and aspects of the invention have been described above, features and steps of the apparatus and method are interchangeable between the embodiments and aspects of the invention. For example, where dimensions are indicated in the examples set out above these are examples of ideal measurements but should not be taken as being indicative of being essential to the performance of the invention.

For example, the retainer plate fixes the seals to the body of the enclosure using screws. However, the retainer plate could also be held in place by using stud welds, rivets or bolts. The screw fixing means in the embodiments above could be replaced with stud welds, rivets, bolts and the like.

For example, the seals are held to the body of the enclosure using a retainer plate. However, the seals could also be glued or epoxied into position. Furthermore, the first seal, as located between the body and the lid can be either fixed for example glued or removable. This is also the case with the second seal, also located between the body and the lid and adjacent to the first seal in the second embodiment. It is not essential for either the first or second seal to be fixed to the body. Additionally, it is not essential for the third seal, as located on the lid, to be fixed or removable. For example, the enclosure in the embodiments above have four sides making a rectangular cross-section. However, the enclosure may have different cross-sectional shapes resulting from the use of different numbers of sides including having only one-side along with a rear and front giving it a circular or oval cross-section.

## Claims

1. An enclosure for containing electrical components, the enclosure comprising:
a body having a rear wall and a front wall having at least one side wall extending therebetween, wherein said front wall has an aperture formed therethrough that allows access to an interior volume of said body;
a first seal extending around said aperture wherein an outermost edge of said first seal encircles said aperture;
a retainer plate having a first surface and a second surface wherein an outermost edge of said retainer plate encircles said aperture and said first seal engages said first surface and said retainer plate fixes said first seal to said body;
a second seal engaging said second surface of said retainer plate wherein an outer edge of said second seal encircles said aperture; and
a lid for covering said aperture of said body wherein said lid engages said first seal and said second seal.

2. An enclosure according to claim 1 wherein said retainer plate applies a compression force to said first seal.

3. An enclosure according to any preceding claim further comprising a third seal adjacent said first seal and engaging said first surface of said retainer plate.

4. An enclosure according to claim 3 wherein said third seal is removable.

5. An enclosure according to claim 3 wherein said third seal is fixed.

6. An enclosure according to any preceding claim wherein said retainer plate comprises a rim wherein said rim engages said body of the enclosure, forming a recess for said first seal to engage.

7. An enclosure according to claim 6 wherein said rim comprises metal.

8. An enclosure according to any preceding claim wherein said second seal is fixed to said lid.

9. An enclosure according to any preceding claim wherein said first seal is fixed to said body of the enclosure.

10. An enclosure according to any preceding claims wherein said first seal is fixed.

11. An enclosure according to any of claims 1 to 9 wherein said first seal is removeable.

12. An enclosure according to any preceding claims wherein said retainer plate comprises at least one second aperture for a fixing member to extend therethrough and removably fix said first seal to said front wall of said body.

13. An enclosure according to any preceding claims wherein said lid comprises a fixing device for fixing said lid to said body of the enclosure.

14. An enclosure according to any preceding claim wherein said second seal comprises neoprene.

15. An enclosure according to any preceding claim wherein said first seal comprises silicone.

16. An enclosure according to any preceding claim wherein said lid comprises a front surface and at least one side extending from said front surface wherein at least one edge of said side engages said first seal.
